# EUROPÄISCHE PATENTSCHRIFT

(11) **EP 0 735 386 B1**
(45) Veröffentlichungstag und Bekanntmachung des Hinweises auf die Patenterteilung: **08.10.2003**
(21) Anmeldenummer: 96104315.5
(22) Anmeldetag: 19.03.1996
(51) Int. Cl.: G02B 1/10, C23C 14/08

(54) **Mittelbrechende optische Schichten**
Optical layers with intermediate refractive index
Couches optiques avec indice de réfraction intermédiaire

(30) Priorität: 30.03.1995 DE 19511663
(43) Veröffentlichungstag der Anmeldung: 02.10.1996
(73) Patentinhaber: MERCK PATENT GmbH, 64293 Darmstadt (DE)
(72) Erfinder: Dombrowski, Reiner, 64739 Höchst (DE)

(56) Entgegenhaltungen:
- EP-A- 0 208 549
- US-A- 4 166 831
- US-A- 5 157 547
- DATABASE WPI Week 7942 Derwent Publications Ltd., London, GB; AN 79-76500b XP002029286 "Optical lens with three-layer anti-reflection coating - which comprise layers of YAG, titania or zirconia and magnesium fluoride" & JP 54 029 380 B (CANON KK) , 22.September 1979
- THIN SOLID FILMS, Bd. 73, Nr. 1, 3.November 1980, SWITZERLAND, Seiten 169-175, XP000647424 PAWLEWICZ ET AL: "High band gap oxide optical coatings for 0.25 and 1.06 um fusion lasers"

## Beschreibung

Dünne Oxidschichten werden in der Technik, insbesondere in der Optik, in großem Umfang als Schutzschichten oder für optische Funktionszwecke verwendet. So können sie als Schutz gegen Korrosion und mechanische Beschädigung oder zur Vergütung der Oberflächen optischer Bauteile und Instrumente, wie insbesondere Linsen, Spiegel, Prismen etc. dienen. Weiterhin werden dünne Oxidschichten zur Herstellung hoch-, mittel- und niedrigbrechender optischer Schichten zur Reflexionserhöhung oder -erniedrigung gebraucht. Hauptanwendungsgebiete sind die Herstellung von Antireflex- und Vergütungsschichten auf optischen Substraten wie Brillengläsern, Linsen für Kameraobjektive, Ferngläser und optische Bauteile für optische Meßinstrumente und für die Lasertechnik. Weiterhin sind dies die Herstellung von Schichten mit bestimmten Brechungsindex und/oder bestimmten optischen Absorptionseigenschaften, beispielsweise bei Interferrenzspiegeln, Strahlenteilern, Wärmefiltern und Kaltlichtspiegeln.

Ausgangsmaterialien zur Herstellung derartiger Oxidschichten sind an sich bekannt. Üblich sind SiO₂ sowie eine Vielfalt von Metalloxiden, gegebenenfalls in Kombination miteinander. Die Auswahl erfolgt im wesentlichen empirisch nach Maßgabe der angestrebten optischen Eigenschaften und der Verarbeitbarkeit. Die Herstellung der Schichten erfolgt nach der an sich bekannten Vakuum-Aufdampftechnik. Zur beispielhaften Illustration sei hier die DE-PS 12 28 489 zitiert, aus der sich Hinweise zu verwendbaren Materialien und zur Verarbeitungstechnik sowie zu den in dem Zusammenhang stehenden Problematiken entnehmen lassen.

Für die Herstellung von mittelbrechenden Schichten, also Schichten, die optische Brechungsindex-Werte zwischen etwa 1,6 und 1,9 (bei einer Wellenlänge von 500 nm) aufweisen, ist die Auswahl an prinzipiell geeigneten Ausgangsstoffen begrenzt. Als Ausgangsmaterialien kommen im wesentlichen die Oxide von Aluminium, Magnesium, Yttrium, Lanthan, Praseodym, auch Cerfluorid und Lanthanfluorid sowie Gemische hiervon in Frage.

Diese an sich geeigneten Materialien haben jedoch eine Reihe von Nachteilen, die sich insbesondere in verarbeitungspraktischer Hinsicht bemerkbar machen.

Ein Gesichtspunkt hierbei ist, daß diese Substanzen hohe Schmelz- und Siedepunkte haben, die außerdem relativ nahe beieinander liegen. Aus praktischer Hinsicht ist es aber wichtig, daß die Aufdampfmaterialien vor dem Beginn einer merklichen Abdampfung vollständig eingeschmolzen sind. Nur dann ist eine gleichmäßige und ausreichende Abdampfrate gewährleistet. Diese ist erforderlich, damit sich auf den zu bedampfenden Objekten homogene und gleichmäßig dicke Schichten ausbilden. Bei den Oxiden von Magnesium und Yttrium ist dies aber unter praktischen Anwendungsbedingungen nicht der Fall. Die genannten Substanzen schmelzen unter den üblichen Arbeitsbedingungen nicht bzw. nicht vollständig ein. Sie sind insgesamt schwierig zu verdampfen und man erhält Schichten mit Schichtdicken-Schwankungen.

Man ist daher bestrebt, durch geeignete Zusätze die Schmelzpunkte der Grundmaterialien herabzusetzen. Zusätze dienen weiterhin dazu, den Brechungsindex in der erhaltenen Schicht in bestimmten Grenzen zu variieren und gezielt einzustellen.

Die Auswahl an geeigneten Zusätzen für diese Zwecke ist durch die Forderung nach Absorptionsfreiheit eingeschränkt. Es kommen daher nur solche Metalloxide als entsprechende Zusätze in Frage, die im nahen infraroten und im sichtbaren Spektralbereich bis in den nahen UV-Wellenlängenbereich (ca. bis 200 nm) keine Absorptionen haben.

Der Einsatz von Substanzgemischen ist an sich in der Vakuum-Aufdampftechnik nicht zu bevorzugen. Der Grund ist der, daß Gemische in der Regel inkongruent verdampfen, d.h. sie verändern im Verlaufe des Verdampfungsprozesses ihre Zusammensetzung und entsprechend verändert sich auch die Zusammensetzung der abgeschiedenen Schichten und somit deren Brechungsindex. Typische Beispiele hierfür sind Tantaloxid-Aluminiumoxid- bzw. Hafniumoxid-Aluminiumoxid-Mischsysteme.

Relevanter Stand der Technik wird in den Dokumenten JP 54029380, EP 0 208 549, US 4,166,831 und "High band gap oxide optical coatings", Thin solid films, Bd. 73 Nr. 1, Seiten 169-175 von W.T. Pawlewicz et al. beschrieben.

Der Erfindung lag nun die Aufgabe zugrunde, Aufdampfmaterialien zur Herstellung mittelbrechender optischer Schichten nach der Vakuumaufdampftechnik zu finden, das die Nachteile der bekannten Materialien nicht aufweist und mit denen sich insbesondere gleichmäßige, homogen zusammengesetzte und im sichtbaren Bereich absorptionsfreie Schichten herstellen lassen.

Überraschend wurde nun gefunden, daß sich Aufdampfmaterialien einer chemischen Zusammensetzung gemäß Formel I

YAlₓO_{z} (I)

mit x = 0,5 - 5 und z = 3/2 · (1 + x)
hervorragend zur Herstellung mittelbrechender optischer Schichten mit Brechungsindex-Werten zwischen etwa 1,6 und 1,9 durch Vakuumbedampfung von optischen Substraten eignen. Es hat sich gezeigt, daß diese Materialien sich problemlos und ohne Spritzen im Vakuum verdampfen lassen und unter den in der Vakuumaufdampftechnik üblichen Arbeitsbedingungen ohne weiteres zu homogenen, absorptionsfreien, stabilen Schichten vom gewünschten Brechungsindex führen.

Gegenstand der Erfindung ist ein Verfahren zur Herstellung von mittelbrechenden optischen Schichten nach Anspruch 1.

Bei den erfindungsgemäßen Aufdampfmaterialien handelt es sich nicht um Gemische der beiden Oxide sondern um Mischoxidverbindungen mit diskreter, stöchiometrisch definierter Zusammensetzung. In diesen Verbindungen liegen Yttriumoxid und Aluminiumoxid im Molverhältnis von 2:1 bis 1:5 vor. Der Sauerstoffgehalt ist jeweils stöchiometrisch.

Bei den erfindungsgemäßen Materialien tritt während der Vakuumverdampfung keine Abgabe von Sauerstoff auf. Unter den üblichen Arbeitsbedingungen bei der Vakuumaufdampftechnik bilden sich ohne weiteres absorptionsfreie Schichten. Hierbei zeigte es sich außerdem, daß die optischen Eigenschaften der erhaltenen Schichten kaum durch Schwankungen des Sauerstoffrestdrucks während der Vakuumbedampfung beeinflußt werden.

Diese Befunde sind im besonderen Maße überraschend und nicht vorhersehbar.

Die erfindungsgemäßen Aufdampfmaterialien lassen sich in der Weise erhalten, daß man Yttriumoxid (Y₂O₃) und Aluminiumoxid (Al₂O₃) im Molverhältnis 2:1 bis 1:5 mischt und an Luftatmosphäre unterhalb der Schmelztemperatur sintert. Ein derartiges Herstellverfahren für die erfindungsgemäßen Aufdampfmaterialien ist Gegenstand der Erfindung. Die gesinterten Produkte liegen in Form harter, grauer bis weißer Körner vor, schmelzen ab einer Temperatur von ca. 1600-1700 °C vollständig ein und lassen sich in einem Vakuum von ca. 10⁻⁴ mbar bei Temperaturen zwischen 1800 °C und 1900 °C verdampfen.

Typische erfindungsgemäße Aufdampfmaterialien besitzen eine chemische Zusammensetzung entsprechend Y₄Al₂O₉ (Molverhältnis Y₂O₃:Al₂O₃ wie 2:1), Y₃Al₅O₁₂ (3:5), Y₂Al₄O₉ (1:2) und YAl₅O₉ (1:5).

Die erfindungsgemäßen Aufdampfmaterialien können in den in der einschlägigen Technik üblichen Vakuum-Aufdampfapparaturen bzw. -Anlagen in bekannter Weise und unter den hierfür gängigen Verarbeitungsbedingungen eingesetzt werden. Die Vakuumbedampfung kann nicht nur durch thermische Verdampfung sondern auch durch Elektronenstrahl-Verdampfung vorgenommen werden.

Mit den erfindungsgemäßen Materialien können auf beliebigen geeigneten optischen Substraten homogene dünne Schichten gleichmäßiger Schichtdicke erzeugt werden, die haftfest und in besonderem Maße gegen mechanische und chemische Einflüsse resistent sind. Die Schichten sind mittelbrechend; ihr Brechungsindex liegt, in Abhängigkeit von der Wellenlänge bei der gemessen wird, bei Werten zwischen etwa 1,6 und 1,9. Die Schichten haben eine hohe Transmission in einem Wellenlängenbereich vom nahen UV (ab etwa 200 nm) über den sichtbaren Bereich bis in das nahe IR (ca. 7000 nm) und sind insbesondere im sichtbaren Wellenlängenbereich frei von Absorptionen.

### Beispiel 1:

Es wird aus
42,9 Gew.% Yttrium(III)oxid
57,1 Gew.% Aluminium(III)oxid (Molverhältnis 1:3)
ein Pulvergemisch hergestellt und dieses granuliert. Die Zusammensetzung ist so gewählt, daß sich eine Verbindung der Formel YAl₃O₆ bildet.

Das Granulat wird an Luftatmosphäre bei einer Temperatur von 1645 °C 5 Stunden gesintert. Das erhaltene Produkt hat einen Schmelzpunkt von etwa 1700 °C.

### Beispiel 2:

Es wird aus
57,1 Gew.% Yttrium(III)oxid
42,9 Gew.% Aluminium(III)oxid (Molverhältnis 3:5)
ein Pulvergemisch hergestellt und dieses granuliert. Die Zusammensetzung ist so gewählt, daß sich eine Verbindung der Formel Y₃Al₅O₁₂ bildet.

Das Granulat wird an Luftatmosphäre bei einer Temperatur von 1645 °C 5 Stunden gesintert. Das erhaltene Produkt hat einen Schmelzpunkt von etwa 1700 °C.

### Beispiel 3: Anwendung

Das Granulat von Beispiel 1 wird in einen Verdampfungstiegel aus Kupfer gefüllt und in eine handelsübliche Vakuumaufdampfapparatur mit Elektronenstrahl-Verdampfung verbracht.

Das zu bedampfende Substrat besteht aus Quarz oder Glas.

Die Beschichtung erfolgt bei einer Temperatur von 1800-1900 °C und einem O₂-Restdruck von 2 × 10⁻⁴ mbar bei einer Substrattemperatur von 150 °C und mit einer Abscheidungsrate von 0,4 nm/sec bis eine Schichtdicke von 360 nm erreicht ist.

Die Schicht hat einen Brechungsindex bei 500 nm von n = 1,58. Die Schicht zeigt keine Absorption im sichtbaren Bereich und bis zu einer Wellenlänge von ca. 200 nm.

Die analoge Verarbeitung des Granulats von Beispiel 2 liefert eine Schicht mit einem Brechungsindex bei 500 nm von n = 1,62.

## Patentansprüche

1. Verfahren zur Herstellung von mittelbrechenden optischen Schichten mit Brechungsindex-Werten zwischen etwa 1,6 und 1,9 durch Bedampfen von optischen Substraten im Vakuum, worin in einem ersten Schritt Aufdampfmaterialien mit einer chemischen Zusammensetzung gemäß Formel I
YAlₓO_{z} I
mit x = 0,5 bis 5 und z =3/2*(1 + x); wobei die Mischoxidverbindungen nach Formel I eine diskrete, stöchiometrisch definierte Zusammensetzung aufweisen, durch Mischen von Y₂O₃ und Al₂O₃ im Molverhältnis 2:1 bis 1:5 und anschließendes Sintem der Mischung an Luftatmosphäre unterhalb der Schmelztemperatur der Mischung hergestellt werden und in einem zweiten Schritt die Substrate mit den Aufdampfmaterialien bedampft werden.

2. Verfahren zur Herstellung von mittelbrechenden optischen Schichten nach Anspruch 1, worin es sich bei dem Aufdampfmaterial nach Formel I um YAl₃O₆ handelt.

3. Verfahren zur Herstellung von mittelbrechenden optischen Schichten nach Anspruch 1, worin es sich bei dem Aufdampfmaterial nach Formel I um Y₄Al₂O_{9,} Y₂Al₄O₉ oder YAl₅O₉ handelt.

4. Verfahren zur Herstellung von mittelbrechenden optischen Schichten nach mindestens einem der vorstehenden Ansprüche, worin das Bedampfen durch Vakuumbedampfung, vorzugsweise durch Elekronenstrahl-Verdampfung vorgenommen wird.

## Claims

1. Process for the production of optical coatings of medium refractive index, having refractive index values of between about 1.6 and 1.9, by vapour deposition on optical substrates in vacuo, wherein vapour-deposition materials having a chemical composition corresponding to the formula I
YAlₓO_{z} I
where x = 0.5 to 5 and z = 3/2*(1 + x); the mixed oxide compounds according to the formula I having a discrete, stoichiometrically defined composition, are prepared in a first step by mixing Y₂O₃ and Al₂O₃ in a molar ratio of from 2:1 to 1:5 and subsequent sintering of the mixture in an air atmosphere below the melting point of the mixture and the substrates are deposition-coated with the vapour-deposition materials in a second step.

2. Process for the production of optical coatings of medium refractive index according to Claim 1, wherein the vapour-deposition material according to the formula I is YAl₃O₆.

3. Process for the production of optical coatings of medium refractive index according to Claim 1, wherein the vapour-deposition material according to the formula I is Y₄Al₂O₉, Y₂Al₄O₉ or YAl₅O₉.

4. Process for the production of optical coatings of medium refractive index according to at least one of the preceding claims, wherein the vapour deposition is effected by vacuum vapour deposition, preferably by electron-beam evaporation.

## Revendications

1. Procédé de réalisation de couches optiques à réfraction moyenne avec des valeurs de réfraction optique entre 1,6 et 1,9 par la vaporisation sous vide de substrats optiques, dans lequel, dans une première étape, des matériaux de vaporisation avec une composition chimique selon la formule 1 :
YAlₓO_{z}
avec x= 0,5 à 5 et z= 3/2*(1+x) ; moyennant quoi les liaisons oxydes mixtes présentent selon la formule 1 une composition discrète définie stoechiométriquement, grâce à un mélange de Y₂O₃ et de Al₂O₃ avec un rapport de moles de 2:1 à 1:5 puis à un frittage du mélange dans l'atmosphère ambiante en dessous de la température de fusion du mélange, sont fabriqués et dans une deuxième étape les substrats sont vaporisés avec ces matériaux de vaporisation.

2. Procédé de réalisation de couches optiques à réfraction moyenne selon la revendication 1, dans lequel le matériau de vaporisation selon la formule 1 est YAl₃O₆.

3. Procédé de réalisation de couches optiques à réfraction moyenne selon la revendication 1, dans lequel le matériau de vaporisation selon la formule 1 est Y₄Al₂O₉, Y₂Al₄O₉ ou YAl₅O₉.

4. Procédé de réalisation de couches optiques à réfraction moyenne selon au moins une des revendications précédentes, dans lequel la vaporisation est réalisée sous vide, de préférence par vaporisation à faisceau d'électrons.
